# EUROPÄISCHE PATENTSCHRIFT

(11) **EP 1 752 557 B1**
(45) Veröffentlichungstag und Bekanntmachung des Hinweises auf die Patenterteilung: **26.11.2008**
(21) Anmeldenummer: 05017403.6
(22) Anmeldetag: 10.08.2005
(51) Int. Cl.: C23C 14/34, H01J 37/34

(54) **Vakuumbeschichtungsanlage mit motorisch angetriebener Drehkathode**
Vacuum coating apparatus with powered rotating cathode
Appareillage de revêtement sous vide avec cathodes rotatives motorisés

(43) Veröffentlichungstag der Anmeldung: 14.02.2007
(73) Patentinhaber: Applied Materials GmbH & Co. KG, 63755 Alzenau (DE)
(72) Erfinder: Sauer, Andreas, 63762 Gorssostheim (DE)
(74) Vertreter: Bockhorni & Kollegen

(56) Entgegenhaltungen:
- EP-A- 0 393 344
- DE-A1- 19 746 988
- US-A- 5 620 577
- US-A1- 2003 136 672
- US-A1- 2004 159 539
- PATENT ABSTRACTS OF JAPAN Bd. 014, Nr. 497 (C-0774), 30. Oktober 1990 (1990-10-30) & JP 02 205669 A (MATSUSHITA ELECTRIC IND CO LTD), 15. August 1990 (1990-08-15)

## Beschreibung

Die vorliegende Erfindung betrifft eine Vakuumbeschichtungsanlage mit motorisch angetriebener Drehkathode und einer Einrichtung zum Ausgleich einer Taumelbewegung der Drehkathode, gemäß dem Oberbegriff des Anspruches 1.

In der Vakuumbeschichtungstechnik finden zunehmend rotierende Beschichtungskathoden (Drehkathoden) Verwendung, die an einem Ende an einer üblicherweise am Kammergehäuse, der die Drehakthoden aufnehmenden Prozesskammer, angeordneten Antriebseinheit angeflanscht sind. Die Drehkathoden können horizontal- oder vertikal ausgerichtet in der Vakuumbeschichtungsanlage angeordnet sein. Erstere (horizontale Vakuumbeschichtungsanlagen) werden z.B. für Glasbeschichtungen und zweitere (vertikale Vakuumbeschichtungsanlagen) bspw. für Displaybeschichtungen eingesetzt. Die Drehkathoden sind in der Regel als ein in der Längsachse rotierendes Rohrtarget mit einem im Rohrinneren feststehenden Magnetsystem ausgeführt. Das von dort ausgehende Magnetfeld durchströmt das Targetmaterial, wodurch die bekannte Magnetronwirkung eintritt. Durch die Rotation erfolgt eine sehr gleichmäßige Abnutzung des Rohrtargets, womit die Standzeiten verlängert und die Kosten gesenkt werden. Fernerhin kann im Rohrinneren ein Kühlsystem untergebracht sein. Bei horizontaler Anordnung der Drehkathoden werden im Allgemeinen zwei Konstruktionsprinzipien unterschieden. Beim ersten Prinzip ist die komplette Antriebseinheit einschließlich der Strom- und Kühlzuführung (Medienzuführung) am Deckel der Vakuumbeschichtungskammer angeordnet, mittels so genannter Endblöcke bzw. Endköpfe an jeweils einem Drehkathodenende, wie z.B. in der Patentschrift US 4,445,997 gezeigt. Eine verbesserte Ausführungsform, bei der die Endblöcke bzw. Endköpfe außerhalb der Prozesskammer angeordnet sind, um die Medienzuführung zu erleichtern, zeigt die DE 100 04 787 A1. Prinzipiell erweist sich dieses Konstruktionsprinzip jedoch beim Wechsel der Drehkathoden bzw. der Rohrtargets als umständlich, da die gesamte Einheit einschließlich des Kammerdeckels von der Vakuumbeschichtungsanlage abgenommen werden muss. Beim zweiten Konstruktionsprinzip ist die Antriebseinheit einschließlich der Medienzuführung an der Kammeraußenwand befestigt, was die Handhabung in aller Regel vereinfacht. Beim Wechsel der Drehkathode bzw. des Rohrtargets wird diese einschließlich des im Rohrinneren befindlichen Magnet- und Kühlsystem von der Antriebseinheit abgeflanscht und bei geöffnetem Kammerdeckel aus der Vakuumbeschichtungskammer gehoben. Anlagen dieses Typs zeigt z.B. die US 5,200,049.

Bis zu einer gewissen Rohrlänge kann die Drehkathode als eine frei auskragende, d.h. einseitig gelagerte Konstruktion ausgeführt sein. Vor allem bei längeren Drehkathoden ist jedoch in Folge der zunehmenden Gewichtmomentbelastung eine zusätzliche Abstützung mittels eines Abstützlagers, meist am freien Drehkathodenende, erforderlich.

Bei den Rohrtargets werden zwei Konstruktionsprinzipien unterschieden. Bei den Rohrtargets des ersten Prinzips handelt es sich um mechanisch stabile und dickwandige Rohre. Bei den Rohrtargets des zweiten Prinzips handelt es sich um sehr dünnwandige Rohre, bei denen auf ein mechanisch stabiles Trägerrohr das eigentliche Targetmaterial (wie z.B. Si, Zn, SiAl), beispielsweise durch Gießen, Plasmaspritzen oder thermisches Fügen (Bonden) aufgebracht wird. Den Rohren beider Konstruktionsprinzipien ist gemein, dass sie in Folge des bei der Herstellung eingebrachten Temperaturverzugs in gewissem Sinne raumgekrümmte Rohrachsen aufweisen, die wegen der harten, spröden und brüchigen Werkstoffe nicht nachbearbeitet, bspw. geradegerichtet werden können. Diese gekrümmten Rohrtargetachsen (Längsachsen der Rohrtargets) verursachen bei einseitig fester Einspannung der Drehkathode am gegenüberliegenden freien Drehkathodenende eine Taumelbewegung mit doppelter Amplitude. Bei einer maximalen Rohrlänge von 4 m sind Abweichungen der Rohrachse von 10 mm keine Seltenheit, was zu einer Taumelbewegung von +/- 10 mm führt. Um trotz dieser Taumelbewegung am freien Ende der Drehkathode noch eine hinreichende Abstützung zu gewährleisten, werden hier meist federgelagerte Abstützungen verwendet, die der Taumelbewegung folgen und diese dämpfen können. Eine solche Abstützung ist z.B. in der US 5,620,577 beschrieben. Durch Vorspannung mindestens einer Feder kann die Abstützkraft eingestellt werden.

Die bekannten Lösungen des zugrunde liegenden Problems, d.h. der Abstützung einer taumelnden Drehkathode, weisen jedoch verschiedene Nachteile auf. Bei Verwendung unterschiedlich schwerer Rohrtargets muss die Federvorspannung des Abstützlagers dem jeweiligen Rohrtargetgewicht angepasst werden. Ferner schwankt die Abstützkraft bei einer vollen Rohrtargetumdrehung um einen Betrag, der sich aus der Federrate der Federung und dem Taumelausschlag ergibt. Da die Rohrtargetmasse während des Betriebs infolge von Sputtererosion abnimmt (auf bis zu 20 % des ursprünglichen Gewichtes), muss die Abstützkraft idealerweise während des Betriebs nachgestellt bzw. nachgeregelt werden. Die sich stets ändernden Bedingungen führen letztlich auch zu extremen Lagerbelastungen im Abstützlager und damit zu vorzeitigem Verschleiß. Es wird daher versucht, die Dimensionierung des Abstützlagers anhand des größten Lastfalles vorzunehmen, was wiederum zu großen Lagern und damit verbundenen hohen Kosten führt.

Die Patentschrift EP 1 365 436 A2 beschreibt einen Drehkathodenantrieb, der bereits in sich konstruktive Maßnahmen zum antriebsseitigen Ausgleich von Taumelbewegungen umsetzt. Dies wird durch eine bewegliche Aufhängung der Getriebeeinheit in einem umgebenden Gehäuse und durch Verzahnungsspiel im Antriebsstrang bewerkstelligt. Konstruktiv sind damit den Freiheitsgraden zum Ausgleich von Taumelbewegungen Grenzen gesetzt. Weiterhin erweist sich die Nachrüstung bestehender Anlagen mit solchen Drehkathodenantrieben als nachteilig, da dies nur mit hohem konstruktivem und finanziellem Aufwand möglich ist. Letzteres betrifft im Prinzip auch den Aufbau neuer Anlagen, der sich entsprechend verteuert.

Aufgabe der Erfindung ist es, eine Drehkathodenlagerung bereitzustellen, die einerseits der Taumelbewegung der Drehkathode folgen und diese dämpfen kann, andererseits aber nicht nachgestellt bzw. nachgeregelt werden muss, und ferner einen einfachen Drehkathodenwechsel bzw. Rohrtargetwechsel ermöglicht. Gleichzeitig soll die Aufgabenlösung auch für bestehende Anlagen verwendbar und vergleichsweise kostengünstig sein.

Diese Aufgabe wird erfindungsgemäß durch die Merkmale des kennzeichnenden Teils des Anspruchs 1 gelöst. Die Merkmale der nachgeordneten Unteransprüche geben vorteilhafte Weiterbildungen an.

Der Erfindung liegt die Überlegung zugrunde, die von der Drehkathode (genau genommen vom Rohrtarget) aufgezwungene Taumelbewegung nicht auf der Seite des Abstützlagers sondern im Wesentlichen auf der Antriebsseite abzufangen. Hierzu wird nunmehr die mit der Drehkathode verflanschte gesamte Antriebseinheit nachgiebig, das heißt in einem definierten Maße beweglich, am Kammergehäuse, insbesondere an einer seitlichen Kammeraußenwand befestigt. Dies wird bewerkstelligt, in dem an der Verbindungsstelle (Montageflansch) zwischen Antriebseinheit und Kammergehäuse eine elastische Zwischenplatte angeordnet wird, die zweckmäßigerweise aus einem Elastomer und vorzugsweise durch eine dicke Gummiplatte gebildet ist. Mit dieser elastischen Zwischenplatte ist es nun der Antriebseinheit möglich, die von der Drehkathode aufgezwungene Taumelbewegung durchzuführen, wobei das Abstützlager des freien Drehkathodenendes nunmehr starr ausgeführt werden kann. Da auf das Abstützlager infolge der starren Ausführung nun keine Gewichtsmomente mehr einwirken, sondern lediglich die Gewichtskraft in Höhe der halben Drehkathodenmasse, kann dieses Abstützlager nun insgesamt kleiner dimensioniert werden, was Konstruktionsraum freigibt und Kosten einspart. Ferner erübrigt sich das Nachstellen bzw. Nachregeln einer Federvorspannung.

Durch das elastische Material der Zwischenplatte wird automatisch auch eine Vakuumdichtung erzielt, so dass weitere Dichtmaßnahmen zur Abdichtung der Prozesskammer an dieser Stelle nicht erforderlich sind, bzw. auf die bisherigen Maßnahmen der antriebsseitigen Abdichtung verzichtet werden kann.

Die Erfindung ist vor allem deshalb auch von Interesse, da bestehende Vakuumbeschichtungsanlagen kostengünstig nachgerüstet werden können, wobei die vorhandenen Antriebseinheiten samt ihrer Zuführungstechniken (Medienzuführung) weiterverwendet werden können. Auch beim Aufbau von neuen Anlagen ist der konstruktive und finanzielle Aufwand zur Umsetzung der Erfindung vergleichsweise gering.

Als zunächst unerwarteter Vorteil hat sich weiterhin gezeigt, dass der Neigungswinkel der Drehkathode in Bezug auf die Kammerwand, der typischerweise im Bereich von 90° liegt, aufgrund des elastischen Verhaltens der Zwischenplatte in einem gewissen Gradbereich gezielt verändert werden kann.

Als weiterer Vorteil ergibt sich, dass die Zwischenplatte die Schwingungsübertragung von der Antriebseinheit auf die Vakuumbeschichtungskammer deutlich reduziert, was die Produktionsqualität erhöht und zur Lärmminderung beiträgt.

Falls die Zwischenplatte aus einem elektrisch nicht leitenden Material gebildet ist, kann sie gleichzeitig als Isolator zwischen dem Kammer- und dem Kathodenpotential dienen. Es kann somit auf andere Isolationsmaßnahmen, beispielsweise den Verbau eines Isolatorblocks, verzichtet werden.

Abhängig von der der konstruktiven Auslegung der Zwischenplatte, insbesondere der Befestigungstechnik, können auch Längsausdehnungen der Drehkathode, bspw. in Folge von Erwärmung und Abkühlung, kompensiert werden, was bisher durch konstruktive Zusatzmaßnahmen berücksichtigt werden musste, wenn hohe Belastungen im Abstützlager bzw. in der Antriebseinheit vermieden werden sollten.

Anhand der beiliegenden Zeichnungen soll ein konkretes Ausführungsbeispiel der Erfindung näher beschrieben. Darin zeigen:
- Fig. 1: die Schnittdarstellung einer horizontalen Vakuumbeschichtungsanlage mit einer Drehkathode, die dem Stand der Technik entspricht
- Fig. 2: die Schnittdarstellung einer horizontalen Vakuumbeschichtungsanlage mit der erfindungsgemäßen Aufhängung der Antriebseinheit
- Fig. 3: eine Detailansicht der Verbindungsstelle zwischen Antriebseinheit und Kammerwand im Schnitt
- Fig. 4: eine Detailansicht der Verbindungsstelle zwischen Antriebseinheit und Kammerwand im Schnitt mit einer alternativen Verbindungstechnik

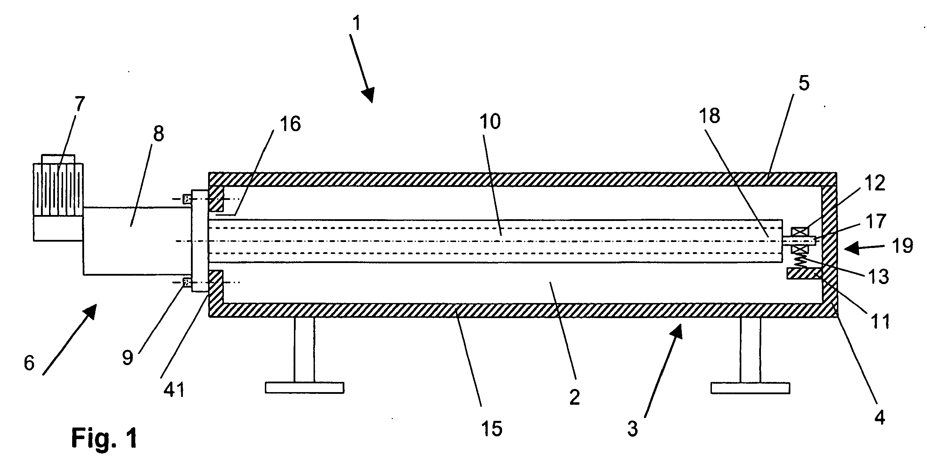

Fig. 1 zeigt eine horizontale Vakuumbeschichtungsanlage 1 wie sie dem Stand der Technik entspricht. Eine Prozesskammer 2 wird durch seitliche Kammerwände 4, einem Kammerboden 15 und einem Kammerdeckel 5 begrenzt, der einen Zugang zur Prozesskammer für Wartungs- und Reparaturarbeiten ermöglicht. Innerhalb der Prozesskammer 2 ist mindestens eine Drehkathode 10 angeordnet, hier in der Ausführung mit einem Rohrtarget. Ebenso könnte die Drehkathode jedoch massiv ausgeführt sein. Nicht dargestellt sind die im Stand der Technik üblichen Einbauten im Inneren der Rohrkathode, beispielsweise ein Magnet-und/oder Kühlsystem und dergleichen. Aus Gründen der Übersichtlichkeit sind auch Auflage- und Transportmittel innerhalb der Prozesskammer 2 für die zu bearbeitenden Werkstücke nicht dargestellt. Diese Mittel sind dem Fachmann bekannt, sodass sich eine Beschreibung erübrigt. Die Drehkathode 10 ist an einem Ende durch eine Wandöffnung 16 in der seitlichen Kammerwand 4 mit einer Antriebseinheit 6 verbunden, vorzugsweise starr angeflanscht. Die Antriebseinheit 6 ist an der Kammeraußenwand 41 befestigt, beispielsweise mit Befestigungsschrauben 9, und umfasst einen Antriebsmotor 7 und einen Getriebe-/Kupplungsblock 8, wobei letzterer auch die diesseitigen Lager für die Drehkathode umfasst. Sowohl die Drehbewegung als auch die für den Prozess erforderliche Medien wie beispielsweise Kühlmittel werden somit antriebsseitig von der Seite in die Prozesskammer eingeleitet bzw. zugeführt. Zum Auswechseln der Drehkathoden 10 wird diese von der Antriebseinheit 6 abgeflanscht und samt ihrer Einbauten nach oben durch den geöffneten Kammerdeckel 5 aus der Prozesskammer 2 gehoben.

Um die von der Drehkathode kommende Gewichtsmomentbelastung auf die Antriebseinheit 6 und deren Befestigungsmittel gering zu halten, ist die Drehkathode an ihrem freien Ende 18, d.h. an dem den Flansch entgegengesetzten Ende, mit einem Abstützlager 19 abgestützt. In dem Ausführungsbeispiel der Figur 1 ist hierzu die Drehkathode 10 durch einen Wellenzapfen 17 fortgesetzt, der von einem Wälzlager 12 aufgenommen ist, wobei das Wälzlager 12 an einer Auflage 11 befestigt ist. In dem dargestellten Ausführungsbeispiel ist das Abstützlager 19 innerhalb der Prozesskammer 2 angeordnet, es ist jedoch auch möglich, die Abstützung außerhalb der Prozesskammer 2 vorzunehmen, wozu die Drehkathode 10 bzw. ein fortgesetzter Wellenzapfen 17 durch eine entsprechende Öffnung in der seitlichen Kammerwand 4 nach außen geführt werden muss, was zusätzlichen konstruktiven Aufwand bedeutet. Als Folge von Fertigungstoleranzen und herstellungsbedingtem thermischen Verzug des Rohrtargets weist die Drehkathode eine im gewissen Sinne raumgekrümmte Rohrachse auf, wobei mehrere Krümmungsradien und Krümmungsrichtungen in einer Drehkathode vorhanden sein können. In Folge der starren Befestigung der Drehkathode 10 an der Antriebseinheit 6 führt somit das freie Drehkathodenende 18 während der Rotation eine mehrdimensionale Taumelbewegung aus. Um dieser Taumelbewegung folgen zu können, weist das Abstützlager 19 eine Federung 13 auf, wobei in dem gezeigten Ausführungsbeispiel der Fig. 1 Dämpfungs- und Vorspannelemente nicht dargestellt sind. Je nach eingebauter Drehkathode 10 und Targetmaterialabnutzung muss die Vorspannung und/oder die Dämpfung der Federung 13 nachgeregelt bzw. manuell nachgeführt werden.

Steht die Achse der Drehkathode 10 nicht im korrekten Winkel zur Kammerwand 4, bspw. im 90°-Winkel, kann durch unterschiedlich starkes Anziehen der Befestigungsschrauben 9, d. h. durch unterschiedlich starke Pressung der Zwischenplatte 14, der Neigungswinkel der Drehkathode 10 bezogen auf die Kammerwand 4 verändert werden. Dies ist insbesondere auch interessant für das Nachrüsten bestehender Anlagen, da auf diese Weise unter Zuhilfenahme eines Zentrierwerkzeuges die Abtriebswellenachse der Antriebseinheit 6 zum Mittelpunkt des gegenüberliegenden Abstützlagers 19 ausgerichtet werden kann. D. h. auch, dass es möglich ist die Antriebseinheit 6 zur Drehkathodenachse auszurichten.

Aus Gründen der Übersichtlichkeit sind in dem gezeigten Ausführungsbeispiel der Fig. 1 Isolationsmittel, bspw. in Form eines Isolatorblocks, die ggf. die unterschiedlichen elektrischen Potentiale zwischen Drehkathode 10 und Antriebseinheit 6 auf der einen Seite und dem Kammergehäuse auf der anderen Seite zueinander isolieren, nicht dargestellt.

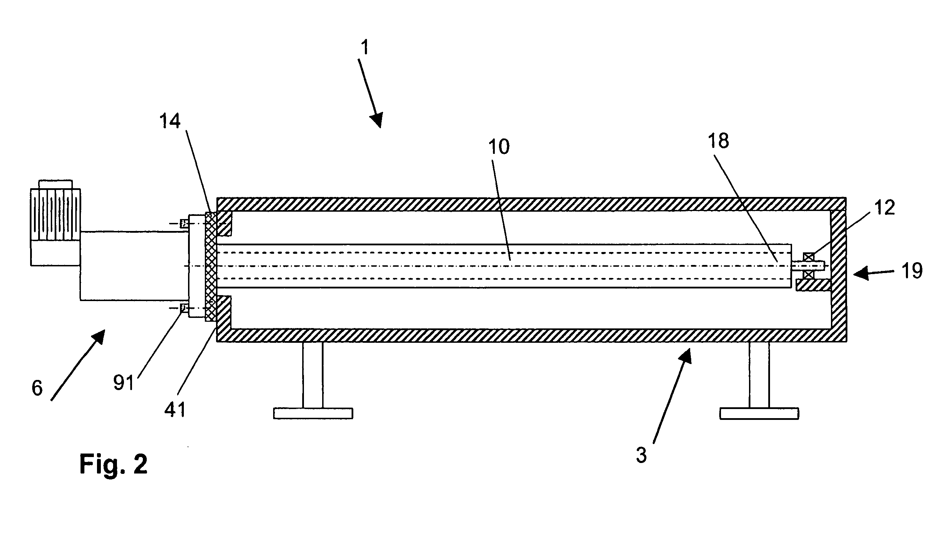

Fig. 2 zeigt eine horizontale Vakuumbeschichtungsanlage mit der erfindungsgemäßen nachgiebigen Aufhängung der Antriebseinheit 6 am Kammergehäuse 3. Die Bezugszeichen für die einzelnen Komponenten sind identisch zu Fig. 1. Erfindungsgemäß liegt hier die Antriebseinheit 6 nicht direkt an der Kammeraußenwand 41 an, sondern mittelbar über eine nachgiebige Zwischenplatte 14, die elastische Materialeigenschaften aufweist. Die Zwischenplatte 14 hat hier bspw. die Form einer Ringscheibe. In Folge der nachgiebigen Aufhängung mittels der Zwischenplatte 14 kann nun die an der Drehkathode 10 angeflanschte Antriebseinheit 6 der Taumelbewegung der Drehkathode folgen, so dass die Abstützung des freien Drehkathodenendes 18 als starre Abstützung ausgeführt werden kann. Es entfällt somit auch die Nachregelung bzw. manuelle Nachführung einer Federung im Abstützlager 19. In Folge der geringeren Momenten- und Zugbelastung auf das Wälzlager 12 kann dieses nun kleiner dimensioniert werden.

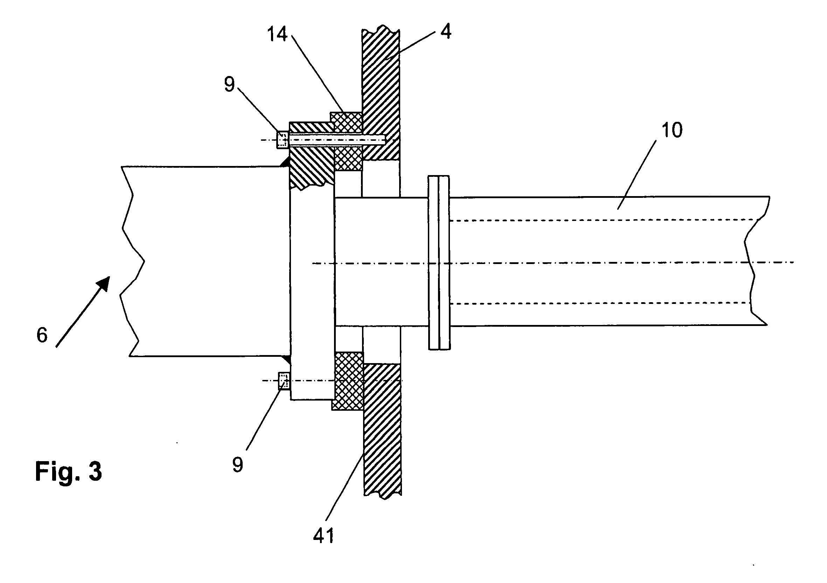

Fig. 3 zeigt eine einfache und kostengünstige Befestigungstechnik der Antriebseinheit 6 an der Kammeraußenwand 41 unter Verwendung einer elastischen Zwischenplatte 14. Die Antriebseinheit 6 ist hier mittels Befestigungsschrauben 9 an der Kammerwand 4 befestigt, wobei sich die Schraubenschäfte durch Bohrungen in der Antriebseinheit 6 und der Zwischenplatte 14 hindurch erstrecken und die Schraubengewinde in entsprechende Gegengewinde in der Kammerwand 4 eingreifen. Die Antriebseinheit 6 liegt somit nicht direkt an der Kammeraußenwand 41 an, sondern über eine elastisch nachgiebige Zwischenplatte 14, wie bereits zuvor erläutert. Aufgrund der nicht starren Verbindung kann sich die Antriebseinheit 6 in einem gewissen Maße relativ zur Kammerwand 4 bewegen. Falls eine elektrische Isolation der unterschiedlichen Potentiale von Kammergehäuse 3 und Antriebseinheit 6 erforderlich ist, können sog. Isolierhülsen für die Schrauben 9 (nicht dargestellt) eingesetzt werden.

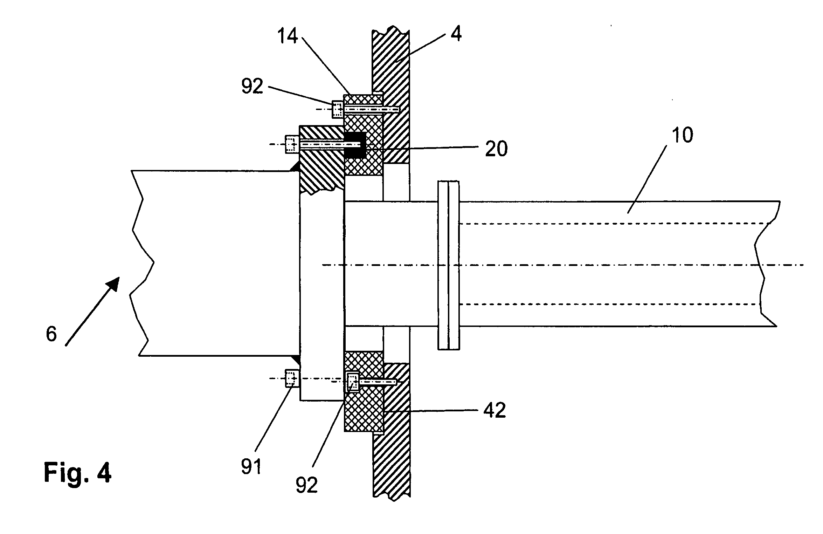

Die Fig. 4 zeigt eine alternative Befestigungstechnik der Antriebseinheit 6 an der Kammerwand 4. Ein Vorteil dieser aufwändigeren Befestigungstechnik liegt in den erweiterten Bewegungsfreiheitsgraden der Antriebseinheit 6 bezüglich der Kammerwand 4. Die Zwischenplatte 14 ist hier mit Schrauben 92 durch Bohrungen hindurch an der seitlichen Kammerwand 4 befestigt. Je nach Anordnung der Schrauben 92 kann es erforderlich sein, eine Ansenkung für die Schraubenköpfe vorzusehen. Die Antriebseinheit 6 wird an der Zwischenplatte 14 mittels Befestigungsschrauben 91 befestigt. Hierzu kann es erforderlich sein, dass die Gewinde innerhalb der Zwischenplatte 14 verstärkt ausgeführt werden, beispielsweise mittels metallischer Gewindeeinsätze. Konstruktive Idee ist hierbei, dass die Befestigungsmittel keine starre Verbindung zwischen Antriebseinheit 6 und Kammerwand 4 herstellen. Als weiterer Vorteil dieser Befestigungstechnik ergibt sich, dass prinzipbedingt eine elektrische Isolation der unterschiedlichen Potentiale von Kammergehäuse 3 und Antriebseinheit 6 gegeben ist.

In einer weiteren nicht gezeigten Ausführungsform werden Befestigungsbolzen von der Antriebseinheit 6 durch die Zwischenplatte 14 geführt und auf der Rückseite der Zwischenplatte 14, d.h. der Seite die der Kammerwand 4 zugewendet ist, gesichert, bspw. mit Muttern, wobei konstruktiv entsprechender Raum vorzusehen ist. Auch andere Verbindungstechniken und -methoden sind denkbar.

Um mit der Zwischenplatte 14 auch eine Vakuumdichtung zwischen Kammerwand 4 und Antriebseinheit 6 zu erzielen, muss die Kammeraußenwand 41 an der entsprechenden Stelle (Flächenabschnitt) überarbeitet werden, um eine Oberfläche in Dichtflächenqualität zu erhalten, wobei die erforderliche Oberflächenqualität maßgeblich von der verwendeten Zwischenplatte 14 abhängig ist. Im dargestellten Ausführungsbeispiel der Fig. 4 ist deshalb ein zurückgesetzter Wandbereich (Aussparung, Einstich) 42 dargestellt, der einem solch überarbeiteten Flächenabschnitt entspricht. Es ist jedoch auch denkbar, dass der Flächenabschnitt nicht als zurückgesetzter Wandbereich, sondern als vorstehender Wandbereich ausgebildet ist. Im Falle eines zurückgesetzten Wandbereiches 42 ergibt sich der Vorteil einer vereinfachten Montage.

Die Zwischenplatte 14 ist aus einem Elastomer, bevorzugt aus einem Gummiwerkstoff, insbesondere aus einem Naturkautschuk oder Silikon gebildet. Die Shorehärte beträgt im Minimum 50° und im Maximum 80°. Ein Bereich von 60° bis 70° Shorhärte wird bevorzugt. Es versteht sich von selbst, dass solche Werkstoffe elektrisch isolierend sind. Materialen für die Zwischenplatte 14 sind als Halbzeuge mit unterschiedlichsten Eigenschaften auf dem Markt erhältlich.

Die Erfindungsidee ist nicht auf horizontale Vakuumbeschichtungsanlagen beschränkt, es ist für den Fachmann ebenso möglich, diese in einer vertikalen Vakuumbeschichtungsanlage, bei der die freien Kathodenenden ebenfalls gelagert sind, umzusetzen. Es ist ebenfalls denkbar die Merkmale der beschriebenen unterschiedlichen Ausführungsformen zu kombinieren.

### Bezugszeichenliste

- 1: Vakuumbeschichtungsanlage
- 2: Prozesskammer
- 3: Kammergehäuse
- 4: Kammerwand
- 5: Kammerdeckel
- 6: Antriebseinheit
- 7: Motor
- 8: Getriebe-/Kupplungsblock einschl. Lager
- 9: Befestigungsschrauben (Antriebseinheit / Kammerwand)
- 10: Drehkathode (Rohrtarget)
- 11: Auflage
- 12: Wälzlager
- 13: Feder (mit Vorspannung und Dämpfung)
- 14: Zwischenplatte
- 15: Kammerboden
- 16: Wandöffnung
- 17: Wellenzapfen
- 18: Freies Drehkathodenende
- 19: Abstützlager
- 20: Metallischer Gewindeeinsatz
- 41: Kammeraußenwand
- 42: Aussparung, Einstich
- 91: Befestigungsschrauben (Antriebseinheit / Zwischenplatte)
- 92: Befestigungsschrauben (Zwischenplatte / Kammerwand)

## Patentansprüche

1. Vakuumbeschichtungsanlage (1) mit wenigstens einer Prozesskammer (2) mit einem Kammergehäuse (3), wenigstens einer gegenüber dem Kammergehäuse (3) gelagerten und mittels einer Antriebseinheit (6) motorisch angetriebenen Drehkathode (10),
sowie mit einer Einrichtung zum Ausgleich einer Taumelbewegung der Drehkathode (10) an deren antriebsseitigem Ende,
**dadurch gekennzeichnet, dass**
die Antriebseinheit (6) der Drehkathode (10) mittels einer nachgiebigen Aufhängung gegenüber dem Kammergehäuse (3) angeordnet ist.

2. Vakuumbeschichtungsanlage gemäß Anspruch 1,
**dadurch gekennzeichnet, dass**
die nachgiebige Aufhängung der Antriebseinheit (6) durch eine, zwischen Kammergehäuse (3) und Antriebseinheit (6) angeordnete, elastische Zwischenplatte (14) ausgeführt ist.

3. Vakuumbeschichtungsanlage gemäß Anspruch 1 oder 2,
**dadurch gekennzeichnet, dass**
die Antriebseinheit (6) mittels Befestigungsschrauben (9), die sich durch Bohrungen in der Antriebseinheit (6) und der Zwischenplatte 14 hindurch erstrecken, an der Kammerwand (4) befestigt ist.

4. Vakuumbeschichtungsanlage gemäß Anspruch 1 oder 2,
**dadurch gekennzeichnet, dass**
die elastische Zwischenplatte (14) nur an dem Kammergehäuse (3) befestigt und die Antriebseinheit (6) nur an der Zwischenplatte (14) befestigt ist.

5. Vakuumbeschichtungsanlage gemäß einem der vorherigen Ansprüche
**dadurch gekennzeichnet, dass**
die Dimension einer Wandöffnung (16) mindestens nach dem Durchmesser des hindurchgeführten Antriebsstranges zuzüglich des doppelten Taumelausschlages der Drehkathode (10) bemessen ist.

6. Vakuumbeschichtungsanlage gemäß einem der vorherigen Ansprüche
**dadurch gekennzeichnet, dass**
die Zwischenplatte (14) aus einem Elastomer, bevorzugt aus einem Gummiwerkstoff, insbesondere aus einem Naturkautschuk oder Silikon gebildet ist.

7. Vakuumbeschichtungsanlage gemäß Anspruch 6
**dadurch gekennzeichnet, dass**
die Shorehärte im Minimum 50° und im Maximum 80° beträgt und bevorzugt im Bereich von 60° bis 70° Shorhärte liegt.

8. Vakuumbeschichtungsanlage gemäß Anspruch 6 oder 7,
**dadurch gekennzeichnet, dass**
die Zwischenplatte (14) aus einem elektrisch nichtleitendem Material gebildet ist.

9. Vakuumbeschichtungsanlage gemäß einem der vorherigen Ansprüche
**dadurch gekennzeichnet, dass**
das Abstützlager (19) des freien Drehkathodenendes (18) als starres Lager ausgeführt ist.

10. Vakuumbeschichtungsanlage gemäß einem der vorherigen Ansprüche
**dadurch gekennzeichnet, dass**
die Kammeraußenwand (41) einen überarbeiteten Flächenabschnitt zur Anlage der Zwischenplatte (14) aufweist, vorzugsweise in Form einer Aussparung bzw. eines Einstiches (42).

## Claims

1. Vacuum coating plant (1) with at least one process chamber (2) with a chamber housing (3) and at least one rotary cathode (10) mounted relative to the chamber housing (3) and motor-driven by a drive unit (6),
and with a device to neutralize wobbling of the rotary cathode (10) at its driven end,
**characterized in that**
the drive unit (6) of the rotary cathode (10) is mounted relative to the chamber housing (3) via a non-rigid suspension.

2. Vacuum coating plant according to Claim 1,
**characterized in that**
the non-rigid suspension of the drive unit (6) is realized by an elastic pad (14) arranged between the chamber housing (3) and drive unit (6).

3. Vacuum coating plant according to Claim 1 or Claim 2,
**characterized in that**
the drive unit (6) is fastened to the chamber wall (4) by means of fixing screws (9) extending through holes in the drive unit (6) and pad (14).

4. Vacuum coating plant according to Claim 1 or Claim 2,
**characterized in that**
the elastic pad (14) is fastened to the chamber housing (3) only, and the drive unit (6) is fastened to the pad (14) only.

5. Vacuum coating plant according to any one of the preceding claims,
**characterized in that**
the size of a wall opening (16) is made at least equal to the diameter of the drive line passing through it plus twice the wobble nutation of the rotary cathode (10).

6. Vacuum coating plant according to any one of the preceding claims,
**characterized in that**
the pad (14) is made of an elastomer, preferably a rubber material, and in particular a natural rubber or silicone.

7. Vacuum coating plant according to Claim 6,
**characterized in that**
the Shore hardness is not less than 50° and not more than 80°, and preferably falls within the range of 60° to 70°.

8. Vacuum coating plant according to Claim 6 or Claim 7,
**characterized in that**
the pad (14) is made of electrically non-conducting material.

9. Vacuum coating plant according to any one of the preceding claims,
**characterized in that**
the bearing (19) supporting the free end (18) of the rotary cathode is realized as a rigid bearing.

10. Vacuum coating plant according to any one of the preceding claims,
**characterized in that**
the chamber outer wall (14) has a machined surface region, preferably in the form of a recessed or cut-in face (42), against which the pad (14) comes to bear.

## Revendications

1. Appareillage de revêtement sous vide (1) comprenant au moins une chambre de traitement (2) dotée d'un boîtier de chambre (3), au moins une cathode rotative (10) logée à l'opposé du boîtier de chambre (3) et entraînée de façon motorisée au moyen d'une unité d'entraînement (6),
et comprenant un dispositif de compensation d'un déplacement basculant de la cathode rotative (10) sur l'extrémité côté entraînement de celle-ci,
**caractérisé en ce que**
l'unité d'entraînement (6) de la cathode rotative (10) est disposée au moyen d'une suspension élastique à l'opposé du boîtier de chambre (3).

2. Appareillage de revêtement sous vide selon la revendication 1,
**caractérisé en ce que**
la suspension flexible de l'unité d'entraînement (6) est réalisée par une plaque intermédiaire élastique (14) disposée entre le boîtier de chambre (3) et l'unité d'entraînement (6).

3. Appareillage de revêtement sous vide selon la revendication 1 ou 2,
**caractérisé en ce que**
l'unité d'entraînement (6) est fixée au moyen de vis de fixation (9), qui s'étendent à travers des alésages dans l'unité d'entraînement (6) et la plaque intermédiaire (14), sur la paroi de chambre (4).

4. Appareillage de revêtement sous vide selon la revendication 1 ou 2,
**caractérisé en ce que**
la plaque intermédiaire élastique (14) n'est fixée qu'au boîtier de chambre (3) et l'unité d'entraînement (6) n'est fixée qu'à la plaque intermédiaire (14).

5. Appareillage de revêtement sous vide selon l'une quelconque des revendications précédentes,
**caractérisé en ce que**
la dimension d'une ouverture de paroi (16) est dimensionnée au moins en fonction du diamètre de la transmission la traversant plus le double du déplacement basculant de la cathode rotative (10).

6. Appareillage de revêtement sous vide selon l'une quelconque des revendications précédentes,
**caractérisé en ce que**
la plaque intermédiaire (14) est formée à partir d'un élastomère, de préférence à partir d'un matériau caoutchouteux, en particulier à partir d'un caoutchouc naturel ou de silicone.

7. Appareillage de revêtement sous vide selon la revendication 6,
**caractérisé en ce que**
la dureté Shore est comprise entre 50° minimum et 80° maximum et se situe de préférence dans la plage allant de 60° à 70°.

8. Appareillage de revêtement sous vide selon la revendication 6 ou 7,
**caractérisé en ce que**
la plaque intermédiaire (14) est formée à partir d'un matériau électriquement non conducteur.

9. Appareillage de revêtement sous vide selon l'une quelconque des revendications précédentes,
**caractérisé en ce que**
le palier d'appui (19) de l'extrémité libre (18) de la cathode rotative est conçu comme un palier rigide.

10. Appareillage de revêtement sous vide selon l'une quelconque des revendications précédentes,
**caractérisé en ce que**
la paroi extérieure de chambre (41) comprend une section de surface réusinée en vue de l'appui de la plaque intermédiaire (14), de préférence sous forme d'un évidement et/ou d'une encoche (42).
